# EUROPEAN PATENT APPLICATION

(11) **EP 4 184 777 A1**
(43) Date of publication of application: **24.05.2023**
(21) Application number: 20949036.6
(22) Date of filing: 12.08.2020
(51) Int. Cl.: H02M 7/02, H02M 7/217, G01R 19/00

(54) **TOTEM-POLE BRIDGELESS POWER FACTOR CORRECTION CIRCUIT AND POWER ELECTRONIC DEVICE**

(71) Applicant: Huawei Digital Power Technologies Co., Ltd., Shenzhen, Guangdong 518043 (CN)
(72) Inventor: CHIN, Ken, Shenzhen, Guangdong 518129 (CN); HU, Zhixiang, Shenzhen, Guangdong 518129 (CN); LIU, Yuanjun, Shenzhen, Guangdong 518129 (CN)
(74) Representative: Isarpatent
(86) International application number: PCT/CN2020/108735
(87) International publication number: WO 2022/032537

(57) **Abstract**

This application discloses a totem-pole bridgeless power factor correction circuit and a power electronics device, and relates to the field of power electronics technologies. The totem-pole bridgeless power factor correction circuit includes a first drive circuit, a rectifier bridge, an inductor, and a current detection circuit; the rectifier bridge includes a first MOS transistor and a first resistor that are located in a first bridge arm; when a voltage of a second output port of an alternating current power supply is a positive voltage, the first drive circuit is configured to drive, based on a first PWM signal, a first port and a second port of the first MOS transistor to be turned on, to enable the alternating current power supply to charge the inductor by using the first MOS transistor; the first resistor is configured to convert a current flowing through the first MOS transistor into a corresponding first voltage signal; the current detection circuit is configured to: when the first voltage signal exceeds a first reference voltage, output an overcurrent signal to the first drive circuit by using an output port; and the first drive circuit is further configured to: when receiving the overcurrent signal, drive the first MOS transistor to be turned off.

## Description

### TECHNICAL FIELD

This application relates to the field of power electronics technologies, and in particular, to a totem-pole bridgeless power factor correction (power factor correction, PFC) circuit and a power electronics device.

### BACKGROUND

To suppress harmonic pollution of an alternating current power network, a PFC circuit is widely used in the field of power electronics technologies. A totem-pole bridgeless PFC circuit can provide high transmission efficiency, and is increasingly widely used.

In the totem-pole (Totem-Pole) bridgeless PFC circuit, pulse width modulation (pulse width modulation, PWM) signals are used to control two metal oxide semiconductor (metal oxide semiconductor, MOS) transistors to be sequentially turned on and off, to control charging and discharging of an inductor, thereby correcting a power factor of the power grid. However, when the MOS transistor is turned on, if a current is excessively high (that is, an overcurrent is generated), the MOS transistor may be damaged.

A solution to prevent the overcurrent from damaging the MOS transistor is to measure a discharge current of the inductor in the totem-pole bridgeless PFC circuit, and shorten a conduction time of the MOS transistor in a next PWM period when the discharge current exceeds a threshold, to prevent the overcurrent from damaging the MOS transistor. However, this solution cannot cope with a transient overcurrent, and in this period, the MOS transistor cannot be turned off in time. Consequently, there is still a risk of damaging the MOS transistor.

### SUMMARY

Embodiments of this application provide a totem-pole bridgeless PFC circuit and a power electronics device, configured to quickly turn off a MOS transistor when an overcurrent is generated, thereby preventing damage to the MOS transistor.

To achieve the foregoing objectives, the following technical solutions are used in embodiments of this application.

According to a first aspect, a totem-pole bridgeless power factor correction circuit is provided, including a first drive circuit, a rectifier bridge, an inductor, and a current detection circuit, where the rectifier bridge includes a first metal oxide semiconductor MOS transistor and a first resistor that are located in a first bridge arm, and a first diode located in a second bridge arm; a first port of the first MOS transistor is connected to a first output port of an alternating current power supply through the first resistor and the inductor, a second port of the first MOS transistor is connected to a cathode of the first diode, and an anode of the first diode is connected to a second output port of the alternating current power supply; an input port of the current detection circuit is connected between the first resistor and the inductor, an output port of the current detection circuit is connected to a second input port of the first drive circuit, an output port of the first drive circuit is connected to a gate of the first MOS transistor, and an input port of the first drive circuit is configured to input a first pulse width modulation PWM signal; one of the first port and the second port of the first MOS transistor is a drain and the other is a source; when a voltage of the second output port of the alternating current power supply is a positive voltage, the first drive circuit is configured to drive, based on the first PWM signal, the first port and the second port of the first MOS transistor to be turned on, to enable the alternating current power supply to charge the inductor by using the first MOS transistor; the first resistor is configured to convert a current flowing through the first MOS transistor into a corresponding first voltage signal; the current detection circuit is configured to: when the first voltage signal exceeds a first reference voltage, output an overcurrent signal to the first drive circuit by using the output port; and the first drive circuit is further configured to: when receiving the overcurrent signal, drive the first MOS transistor to be turned off.

According to the totem-pole bridgeless power factor correction circuit provided in an embodiment of this application, when the first voltage signal corresponding to the current flowing through the first MOS transistor is greater than the first reference voltage, that is, the current flowing through the first MOS transistor is greater than a threshold, a first comparator outputs the overcurrent signal to the first drive circuit, to trigger a first trigger to reset, thereby turning off the first MOS transistor. Therefore, the MOS transistor is quickly turned off when an overcurrent is generated, thereby preventing damage to the MOS transistor.

In a possible implementation, the first drive circuit includes a first OR gate and the first trigger, the first OR gate is configured to input a phase-inverted signal of the first pulse width modulation PWM signal and the overcurrent signal, an output port of the first OR gate is connected to a reset port of the first trigger, a data input port of the first trigger is configured to input the first PWM signal, and a data output port of the first trigger is connected to the gate of the first MOS transistor. This implementation provides a possible structure of the first drive circuit.

In a possible implementation, the first drive circuit further includes a first one shot, a second one shot, a NOT gate, and a first amplifier; and an input port of the first one shot and an input port of the NOT gate are configured to input the first PWM signal, an output port of the first one shot is connected to the data input port of the first trigger, an output port of the NOT gate is connected to an input port of the second one shot, the output port of the NOT gate is configured to output the phase-inverted signal of the first PWM signal, an output port of the second one shot is connected to a first input port of the first OR gate, a second input port of the first OR gate is configured to input the overcurrent signal, the data output port of the first trigger is connected to an input port of the first amplifier, and an output port of the first amplifier is connected to the gate of the first MOS transistor. This implementation provides another possible structure of the first drive circuit.

In a possible implementation, the current detection circuit includes the first comparator, a non-inverting input of the first comparator is configured to input the first voltage signal, and an inverting input of the first comparator is configured to input the first reference voltage; and when the first voltage signal is greater than the first reference voltage, the first comparator outputs the overcurrent signal to the first drive circuit. This implementation provides a possible structure of the current detection circuit.

In a possible implementation, the current detection circuit further includes a sixth one shot, an output port of the first comparator is connected to an input port of the sixth one shot, and the first comparator outputs the overcurrent signal by using an output port of the sixth one shot. This implementation provides another possible structure of the current detection circuit.

In a possible implementation, the totem-pole bridgeless power factor correction circuit further includes a PWM signal generation circuit, an overcurrent state detection circuit, and a second resistor; the rectifier bridge further includes a second MOS transistor located in a third bridge arm, and a second diode located in a fourth bridge arm, a first port of the second MOS transistor is connected between the first resistor and the inductor, a second port of the second MOS transistor is connected to an anode of the second diode, and a cathode of the second diode is connected to the second output port of the alternating current power supply; one of the first port and the second port of the second MOS transistor is a drain and the other is a source; a first input port of the overcurrent state detection circuit is configured to input the first PWM signal, a second input port of the overcurrent state detection circuit is connected between the second port of the second MOS transistor and the anode of the second diode through the second resistor, and an output port of the overcurrent state detection circuit is connected to an input port of the PWM signal generation circuit; the PWM signal generation circuit is configured to generate the first PWM signal; if the first MOS transistor is turned off due to the overcurrent signal, the inductor discharges by using the second MOS transistor; the second resistor is configured to convert a current flowing through the second MOS transistor into a corresponding second voltage signal; the overcurrent state detection circuit is configured to: when the second voltage signal is greater than a second reference voltage, output an overcurrent state signal to the PWM signal generation circuit by using the output port; and the PWM signal generation circuit is configured to: when receiving the overcurrent state signal, stop outputting the first PWM signal. In this implementation, the PWM signal that controls the first MOS transistor can be further reset when the inductor discharges and generates an overcurrent.

In a possible implementation, the totem-pole bridgeless power factor correction circuit further includes a PWM signal generation circuit, an overcurrent state detection circuit, and a second resistor; the rectifier bridge further includes a second MOS transistor located in a third bridge arm, and a second diode located in a fourth bridge arm, a first port of the second MOS transistor is connected between the first resistor and the inductor, a second port of the second MOS transistor is connected to an anode of the second diode through the second resistor, and a cathode of the second diode is connected to the second output port of the alternating current power supply; one of the first port and the second port of the second MOS transistor is a drain and the other is a source; a first input port of the overcurrent state detection circuit is configured to input the first PWM signal, a second input port of the overcurrent state detection circuit is connected between the second port of the second MOS transistor and the second resistor, and an output port of the overcurrent state detection circuit is connected to an input port of the PWM signal generation circuit; the PWM signal generation circuit is configured to generate the first PWM signal; if the first MOS transistor is turned off due to the overcurrent signal, the inductor discharges by using the second MOS transistor; the second resistor is configured to convert a current flowing through the second MOS transistor into a corresponding third voltage signal; the overcurrent state detection circuit is configured to: when the third voltage signal is less than a third reference voltage, output an overcurrent state signal to the PWM signal generation circuit by using the output port; and the PWM signal generation circuit is configured to: when receiving the overcurrent state signal, stop outputting the first PWM signal. In this implementation, the PWM signal that controls the first MOS transistor can be further reset when the inductor discharges and generates an overcurrent.

In a possible implementation, the overcurrent state detection circuit includes a second comparator and an AND gate, a non-inverting input of the second comparator is configured to input the second voltage signal, an inverting input of the second comparator is configured to input the second reference voltage, an output port of the second comparator is connected to the AND gate, and the AND gate is further configured to input the first PWM signal; and when the second voltage signal is greater than the second reference voltage, the AND gate outputs the overcurrent state signal. This implementation provides a possible structure of the overcurrent state detection circuit.

In a possible implementation, the overcurrent state detection circuit includes a second comparator and an AND gate, a non-inverting input of the second comparator is configured to input the third reference voltage, an inverting input of the second comparator is configured to input the third voltage signal, an output port of the second comparator is connected to the AND gate, and the AND gate is further configured to input the first PWM signal; and when the third voltage signal is less than the third reference voltage, the AND gate outputs the overcurrent state signal. This implementation provides another possible structure of the overcurrent state detection circuit.

In a possible implementation, the overcurrent state detection circuit further includes a seventh one shot; and an output port of the AND gate is connected to an input port of the seventh one shot, and the AND gate outputs the overcurrent state signal by using an output port of the seventh one shot. This implementation provides still another possible structure of the overcurrent state detection circuit.

In a possible implementation, the PWM signal generation circuit includes a second OR gate and a third trigger, the second OR gate is configured to input a reset signal of the first PWM signal and the overcurrent state signal, an output port of the second OR gate is connected to a reset port of the third trigger, a data input port of the third trigger is configured to input a set signal of the first PWM signal, and an output port of the third trigger is configured to output the first PWM signal. This implementation provides a possible structure of the PWM signal generation circuit.

According to a second aspect, a power electronics device is provided, including the totem-pole bridgeless power factor correction circuit according to any one of the first aspect and the implementations thereof and a working circuit, where the totem-pole bridgeless power factor correction circuit is configured to output a direct current to the working circuit. For technical effects of the power electronics device, refer to the content of any one of the first aspect and the implementations thereof.

### BRIEF DESCRIPTION OF DRAWINGS

FIG. 1 is a schematic diagram of a power electronics device according to an embodiment of this application;
FIG. 2 is a schematic diagram of a structure of a totem-pole bridgeless PFC circuit according to an embodiment of this application;
FIG. 3 is a schematic diagram of structures of a level shift circuit and a first drive circuit according to an embodiment of this application;
FIG. 4 is a schematic diagram of a structure of a second drive circuit according to an embodiment of this application;
FIG. 5 is a schematic diagram of a structure of a zero-current-detect circuit according to an embodiment of this application;
FIG. 6 is a schematic diagram of a structure of another totem-pole bridgeless PFC circuit according to an embodiment of this application;
FIG. 7 is a schematic diagram of a structure of still another totem-pole bridgeless PFC circuit according to an embodiment of this application;
FIG. 8 is a schematic diagram of structures of a current detection circuit and a first drive circuit according to an embodiment of this application;
FIG. 9 is a schematic diagram of a structure of an overcurrent state detection circuit according to an embodiment of this application;
FIG. 10 is a schematic diagram of a structure of another overcurrent state detection circuit according to an embodiment of this application;
FIG. 11 is a schematic diagram of a structure of a PWM generation circuit according to an embodiment of this application;
FIG. 12 is a schematic diagram of each signal time sequence according to an embodiment of this application;
FIG. 13 is another schematic diagram of each signal time sequence according to an embodiment of this application; and
FIG. 14 is still another schematic diagram of each signal time sequence according to an embodiment of this application.

### DESCRIPTION OF EMBODIMENTS

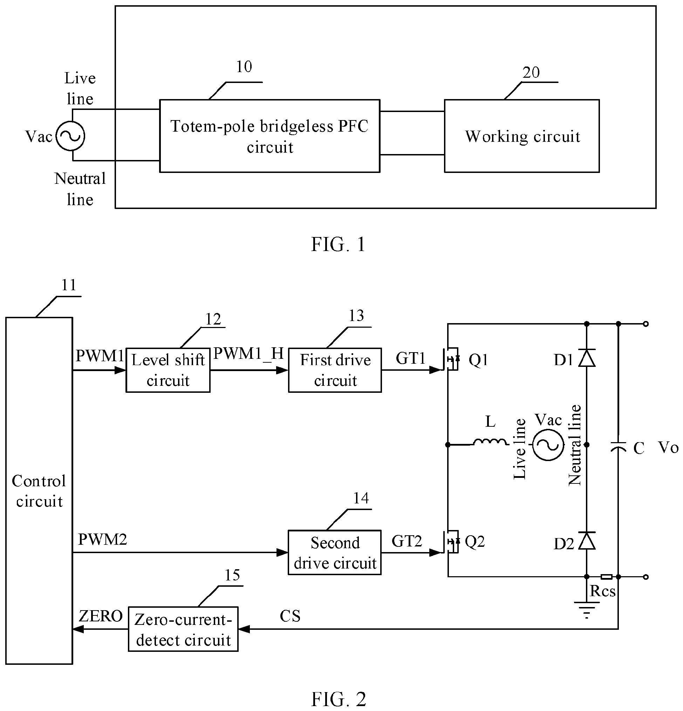

As shown in FIG. 1, an embodiment of this application provides a power electronics device, including a totem-pole bridgeless PFC circuit 10 and a working circuit 20. An alternating current output by an alternating current power supply Vac is input to the totem-pole bridgeless PFC circuit 10 through a live line (live line) and a neutral line (neutral line). The totem-pole bridgeless PFC circuit 10 outputs a direct current from an output port Vo after performing PFC on the alternating current, to supply power to the working circuit 20. The alternating current power supply Vac may be an alternating current power network.

The following describes a possible structure of a totem-pole bridgeless PFC circuit.

As shown in FIG. 2, an embodiment of this application provides a totem-pole bridgeless PFC circuit, including a control circuit 11, a level shift (level shift) circuit 12, a first drive circuit 13, a second drive circuit 14, a zero-current-detect circuit 15, a rectifier bridge, an inductor L, a resistor Res, and a capacitor C. The rectifier bridge includes a first MOS transistor Q1 located in a first bridge arm, a first diode D1 located in a second bridge arm, a second MOS transistor Q2 located in a third bridge arm, and a second diode D2 located in a fourth bridge arm.

A first alternating current input port of the rectifier bridge is connected to a first output port of the alternating current power supply Vac by using the inductor L, and a second alternating current input port of the rectifier bridge is connected to a second output port of the alternating current power supply Vac. A direct current output port of the rectifier bridge is configured to output a direct current Vo.

For example, a first port of the first MOS transistor Q1 and a second port of the second MOS transistor Q2 are connected to one end of the inductor L; the other end of the inductor L is connected to the first output port (for example, a live line) of the alternating current power supply Vac; the second output port (for example, a neutral line) of the alternating current power supply is connected to an anode of the first diode D1 and a cathode of the second diode D2; a second electrode of the first MOS transistor Q1, a cathode of the first diode D1, and a positive electrode of the capacitor C are connected; a first port of the second MOS transistor Q2, an anode of the second diode D2, and a first port of the resistor Res are connected; and a second port of the resistor Rcs is connected to a cathode of the capacitor C. The resistor Rcs is configured to convert a current flowing through the second MOS transistor Q2 into a voltage CS. One of the first port and the second port of the foregoing MOS transistor is a drain and the other is a source. In the figure, for example, the first port is the drain, and the second port is the source, which is not intended to be limited thereto.

A first PWM signal output port of the control circuit 11 is connected to a control port (a gate) of the first MOS transistor Q1 through the level shift circuit 12 and the first drive circuit 13, and a second PWM signal output port of the control circuit 11 is connected to a control port (a gate) of the second MOS transistor Q2 through the second drive circuit 14. The second port of the resistor Rcs and a negative electrode of the capacitor C are further connected to a first input port of the control circuit 11 through the zero-current-detect circuit 15.

The control circuit 11 controls, by outputting PWM signals (square wave signals), the first MOS transistor Q1 and the second MOS transistor Q2 to be sequentially turned on and off, to control charging and discharging of the inductor L, thereby performing power factor correction on an alternating current output by the alternating current power supply Vac, to obtain a stable output voltage Vo.

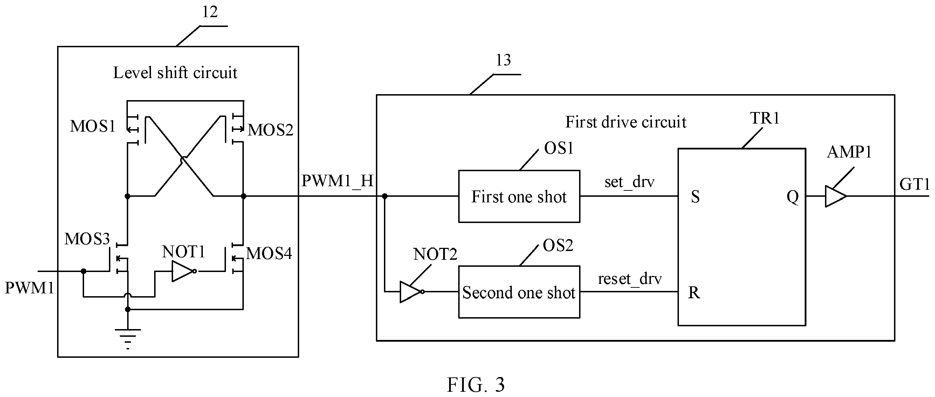

As shown in FIG. 3, the level shift circuit 12 includes a MOS transistor MOS1, a MOS transistor MOS2, a MOS transistor MOS3, a MOS transistor MOS4, and a NOT gate NOT1. A source of the MOS transistor MOS1 is connected to a source of the MOS transistor MOS2; a drain of the MOS transistor MOS1, a gate of the MOS transistor MOS2, and a drain of the MOS transistor MOS3 are connected; a drain of the MOS transistor MOS2, a gate of the MOS transistor MOS1, and a drain of the MOS transistor MOS4 are connected; a source of the MOS transistor MOS3 and a source of the MOS transistor MOS4 are grounded; and a gate of the MOS transistor MOS3 is connected to the gate of the MOS transistor MOS4 after being inverted by the NOT gate NOT1. The gate of the MOS transistor MOS3 is configured to receive a first PWM signal PWM1 output by the control circuit 11, and the drain of the MOS transistor MOS2 and the drain of the MOS transistor MOS4 are configured to output a PWM signal PWM1_H obtained after the first PWM signal PWM1 is boosted.

As shown in FIG. 3, the first drive circuit 13 includes a first one shot OS1, a second one shot OS2, a NOT gate NOT2, a first trigger TR1, and a first amplifier AMP 1. An input port of the first one shot (one shot) OS1 and an input port of the NOT gate NOT2 are configured to input the PWM signal PWM1_H; an output port of the first one shot OS1 is connected to a data input port S of the first trigger TR1; an output port of the NOT gate NOT2 is connected to an input port of the second one shot OS2; an output port of the second one shot OS2 is connected to a reset port R of the first trigger TR1, a data output port Q of the first trigger TR1 is connected to an input port of the first amplifier AMP 1; and an output port of the first amplifier AMP 1 is configured to be connected to the gate of the first MOS transistor Q1, to output a drive signal GT1 of the first MOS transistor Q1.

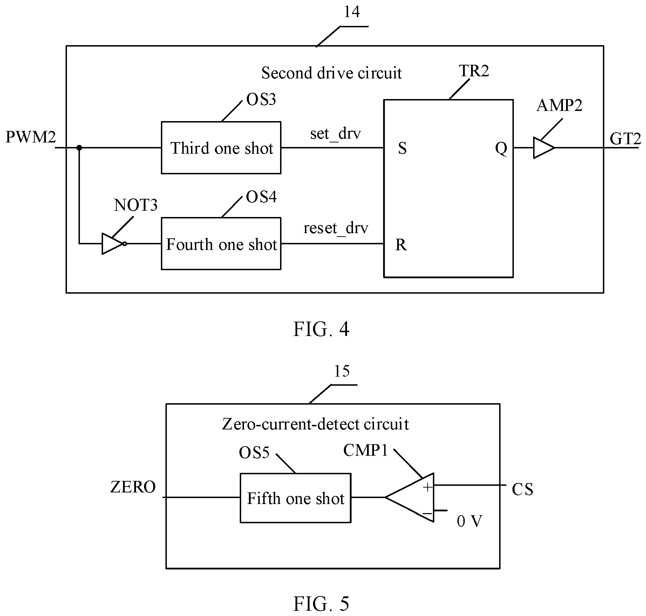

As shown in FIG. 4, the second drive circuit 14 includes a third one shot OS3, a fourth one shot OS4, a NOT gate NOT3, a second trigger TR2, and a second amplifier AMP2. An input port of the third one shot OS3 and an input port of the NOT gate NOT3 are configured to input a second PWM signal PWM2 output by the control circuit 11; an output port of the third one shot OS3 is connected to a data input port S of the second trigger TR2; an output port of the NOT gate NOT3 is connected to an input port of the fourth one shot OS4; an output port of the fourth one shot OS4 is connected to a reset port R of the second trigger TR2; a data output port Q of the third trigger TR3 is connected to an input port of the second amplifier AMP2; and an output port of the second amplifier AMP2 is configured to be connected to the gate of the second MOS transistor Q2, to output a drive signal GT2 of the second MOS transistor Q2.

As shown in FIG. 5, the zero-current-detect circuit 15 includes a first comparator CMP1 and a fifth one shot OS5. A non-inverting input + of the first comparator CMP1 inputs a voltage CS (obtained by converting a current by the resistor Rcs) corresponding to a discharge current (namely, a current flowing through the second MOS transistor Q2) of the inductor L, an inverting input - of the first comparator CMP1 inputs a 0-V reference voltage, and an output port of the first comparator CMP1 is configured to output a detection signal ZERO.

A working principle of the totem-pole bridgeless PFC circuit is as follows: When a voltage of the neutral line of the alternating current power supply Vac is a positive voltage, the PWM signal PWM1_H obtained after the first PWM signal PWM1 output by the control circuit 11 is boosted by the level shift circuit 12 is at a high level, the first drive circuit 13 drives the first MOS transistor Q1 to be turned on, and the alternating current power supply Vac charges the inductor L by using the first MOS transistor Q1. When a conduction time of the first MOS transistor Q1 reaches a specified value, the first PWM signal PWM1 output by the control circuit 11 is at a low level after being boosted by the level shift circuit 12, and the level shift circuit 12 and the first drive circuit 13 drive the first MOS transistor Q1 to be turned off. In addition, the second PWM signal PWM2 output by the control circuit 11 is at a high level, the second drive circuit 14 drives the second MOS transistor Q2 to be turned on, and the inductor L discharges by using the second MOS transistor Q2. The zero-current-detect circuit 15 detects, by using the resistor Res, a voltage corresponding to the discharge current of the inductor L. When the discharge current of the inductor L (namely, a voltage of the resistor Rcs) reaches near zero, the zero-current-detect circuit 15 outputs the detection signal ZERO. After the control circuit 11 receives the detection signal ZERO, when the output second PWM signal PWM2 is at a low level, and the second MOS transistor Q2 is turned off; and when the output first PWM signal PWM1 is at a high level, the first MOS transistor Q1 is turned on.

However, when the voltage of the neutral line is a positive voltage and the first MOS transistor Q1 is turned on to enable the inductor L to be charged, a current of the first MOS transistor Q1 is not detected in the foregoing circuit. When an overcurrent occurs, the first MOS transistor Q1 is damaged.

In a possible implementation, an overcurrent of the first MOS transistor Q1 is detected by using a current transformer (current transformer, CT), and then a current signal is converted into a voltage signal by using the resistor and the diode, to trigger non- conduction of the MOS transistor. However, the CT that occupies a large area needs to be used in this solution, which is not conducive to product miniaturization design and power density improvement.

In another possible implementation, an auxiliary winding is added to the inductor L, and a voltage signal of the auxiliary winding passes through an RC circuit, a clamp tube, and a rectifier tube to obtain an approximate current signal, to trigger non-conduction of the MOS transistor. However, circuit costs of this solution are high due to a need for the auxiliary winding and a plurality of rectifier components. In addition, an inductor abnormality cannot be used, to be specific, when being short-circuited, the inductor cannot work, and consequently, overcurrent protection cannot be implemented.

In still another possible implementation, additional detection of a discharge peak signal of an inductive current is performed. When an inductor discharge peak exceeds a threshold, a conduction time of the MOS transistor is gradually shortened, to prevent an overcurrent. However, this solution cannot be applied to a transient overcurrent, the MOS transistor cannot be turned off in time, and only a conduction time in next period can be shortened. Consequently, there is still a risk of damage.

The totem-pole bridgeless PFC circuit provided in this embodiment of this application may be integrated into an integrated circuit (integrated circuit, IC) chip, to reduce a system cost and a volume of a totem-pole PFC power supply, and quickly turn off the MOS transistor when an inductive current exceeds the threshold, thereby implementing a safe overcurrent protection function.

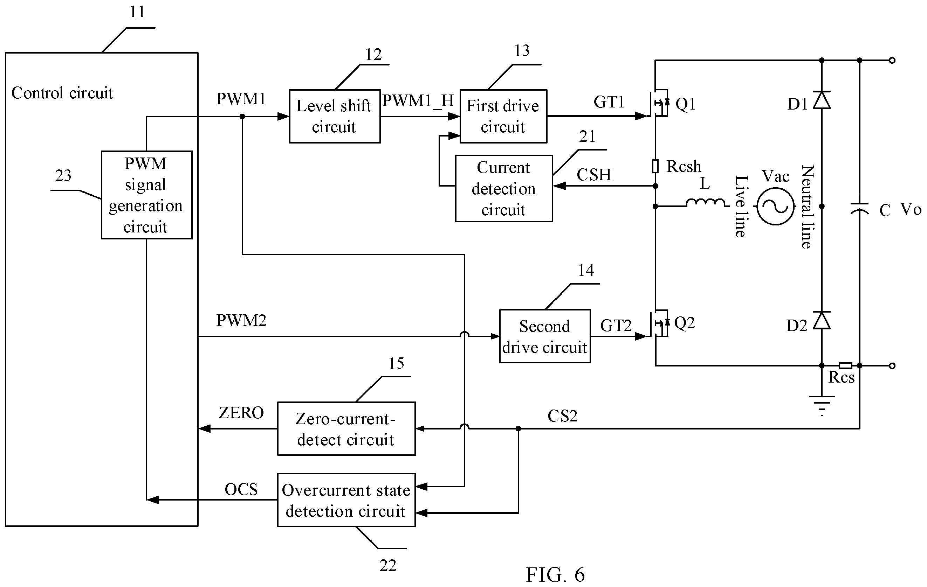

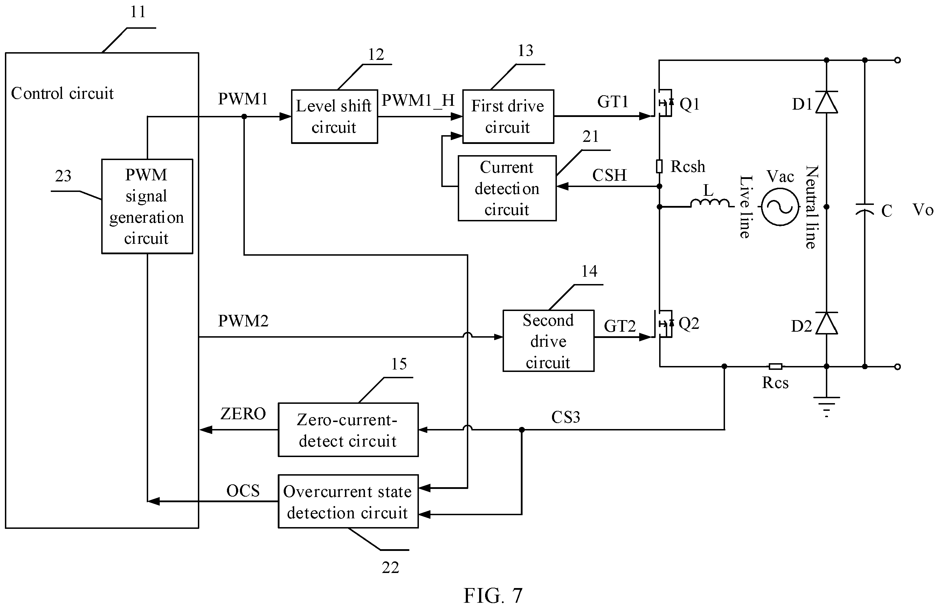

Specifically, as shown in FIG. 6 and FIG. 7, an embodiment of this application provides another totem-pole bridgeless PFC circuit. Compared with the PFC circuit shown in FIG. 2, the PFC circuit further includes a current detection circuit 21, an overcurrent state detection circuit 22, a first resistor Rcsh located in the first bridge arm, and the control circuit 11 further includes a PWM signal generation circuit 23.

In addition, in comparison with FIG. 2, in FIG. 7, the first port of the first MOS transistor Q1 is connected to the first output port of the alternating current power supply Vac through the first resistor Rcsh and the inductor L; the first port of the second MOS transistor Q2 is connected between the first resistor Rcsh and the inductor L; a first port of a second resistor Rcs is connected to the drain of the second MOS transistor Q2; a second port of the resistor Res is connected to the anode of the second diode D2 and the cathode of the capacitor C; and the first port of the resistor Rcs is connected to the first input port of the control circuit 11 through the zero-current-detect circuit 15. An input port of the current detection circuit 21 is connected between the first resistor Rcsh and the inductor L; an output port of the current detection circuit 21 is connected to a second input port of the first drive circuit 13; a first input port of the first drive circuit 13 is configured to input the first PWM signal PWM1; and an output port of the first drive circuit 13 is connected to the control port (the gate) of the first MOS transistor Q1. A first input port of the overcurrent state detection circuit 22 is configured to input the first PWM signal PWM1. As shown in FIG. 6, a second input port of the overcurrent state detection circuit 22 is connected between the second port of the second MOS transistor Q2 and the anode of the second diode D2 through the second resistor Rcs. Alternatively, as shown in FIG. 7, the second input port of the overcurrent state detection circuit is connected between the second port of the second MOS transistor Q2 and the second resistor Res.

When a voltage of the second output port (for example, the neutral line) of the alternating current power supply Vac is a positive voltage, and the first drive circuit drives, based on the first PWM signal PWM1, the first port and the second port of the first MOS transistor Q1 to be turned on, the alternating current power supply Vac is enabled to charge the inductor L by using the first MOS transistor Q1. The first resistor Rcsh is configured to convert a current flowing through the first MOS transistor Q1 into a corresponding first voltage signal CSH. When the first voltage signal CSH exceeds a first reference voltage ref_oc1, the current detection circuit 21 outputs an overcurrent signal to the first drive circuit 13 by using the output port. When the first drive circuit 13 receives the overcurrent signal, the first MOS transistor Q1 is driven to be turned off.

As shown in FIG. 6, if the first MOS transistor Q1 is turned off due to the overcurrent signal, the inductor L discharges by using the second MOS transistor Q2. The second resistor Rcs is configured to convert the current flowing through the second MOS transistor Q2 into a corresponding second voltage signal CS2. When the second voltage signal CS2 is greater than a second reference voltage ref_oc2, the overcurrent state detection circuit 22 outputs an overcurrent state signal OCS to the PWM signal generation circuit 23 by using an output port. When receiving the overcurrent state signal OCS, the PWM signal generation circuit 23 stops outputting the first PWM signal PWM1, that is, resets the first PWM signal PWM1, or outputs the first PWM signal PWM1 at a low level.

Alternatively, as shown in FIG. 7, if the first MOS transistor Q1 is turned off due to the overcurrent signal, the inductor L discharges by using the second MOS transistor Q2. The second resistor Res is configured to convert the current flowing through the second MOS transistor Q2 into a corresponding third voltage signal CS3. When the third voltage signal CS3 is greater than a third reference voltage ref_oc3, the overcurrent state detection circuit 22 outputs the overcurrent state signal OCS to the PWM signal generation circuit 23 by using the output port. When receiving the overcurrent state signal OCS, the PWM signal generation circuit 23 stops outputting the first PWM signal PWM1, that is, resets the first PWM signal PWM1, or outputs the first PWM signal PWM1 at a low level.

The following describes a possible structure of each circuit.

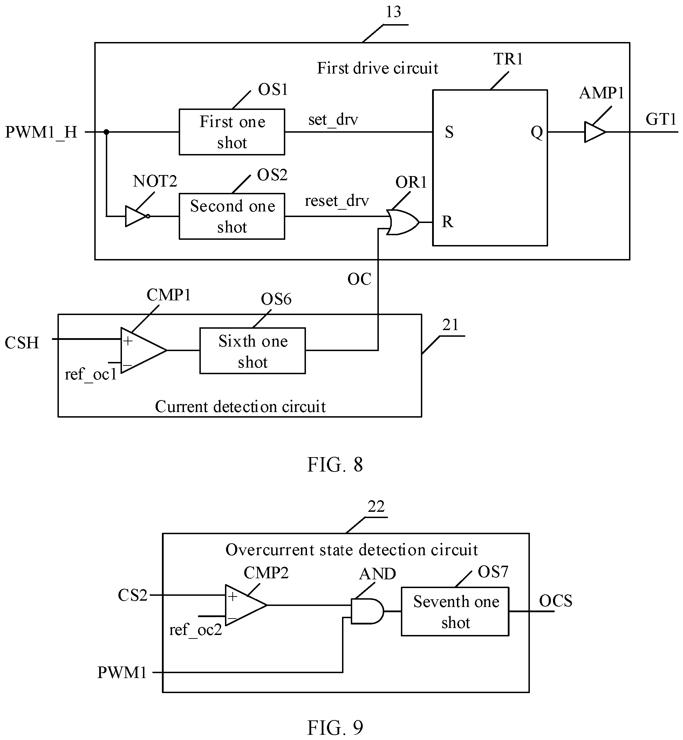

In a possible implementation, as shown in FIG. 8, the current detection circuit 21 includes the first comparator CMP1, and optionally, further includes a sixth one shot OS6. The non-inverting input + of the first comparator CMP1 inputs the first voltage signal CSH corresponding to the current flowing through the first MOS transistor Q1, and the inverting input - of the first comparator CMP1 inputs the first reference voltage ref_oc1 corresponding to a first threshold. When the first voltage signal CSH is greater than the first reference voltage ref_oc1, the first comparator CMP1 outputs the overcurrent signal to the first drive circuit 13. Optionally, the output port of the first comparator CMP1 is connected to an input port of the sixth one shot OS6, and the first comparator CMP1 outputs the overcurrent signal OC by using an output port of the sixth one shot OS6.

In a possible implementation, as shown in FIG. 8, the first drive circuit 13 includes a first OR gate OR1 and the first trigger TR1, and optionally, further includes the first one shot OS1, the second one shot OS2, the NOT gate NOT2, and the first amplifier AMP 1. The first OR gate OR1 is configured to input a reverse signal of the first PWM signal and the overcurrent signal OC; an output port of the first OR gate OR1 is connected to the reset port R of the first trigger TR1; the data input port S of the first trigger TR1 is configured to input the first PWM signal; and the data output port of the first trigger TR1 is configured to be connected to the gate of the first MOS transistor Q1.

Specifically, the input port of the second one shot OS2 and the input port of the NOT gate NOT are configured to input the PWM signal PWM1_H obtained after the first PWM signal is boosted; the output port of the first one shot OS1 is connected to the data input port S of the first trigger TR1; the output port of the NOT gate NOT2 is connected to the input port of the second one shot OS2; the output port of the second one shot OS2 is connected to a first input port of the first OR gate OR1; a second input port of the first OR gate OR1 is configured to input the overcurrent signal OC; the data output port Q of the first trigger TR1 is connected to the input port of the first amplifier AMP1; and the output port of the first amplifier AMP1 is connected to the gate of the first MOS transistor Q1, to amplify the drive signal GT1 of the first MOS transistor Q1.

In a possible implementation, as shown in FIG. 9, the overcurrent state detection circuit 22 includes a second comparator CMP2 and an AND gate AND, and optionally, further includes a seventh one shot OS7. A non-inverting input + of the second comparator CMP2 is configured to input the second voltage signal CS2 corresponding to the current flowing through the second MOS transistor Q2; an inverting input - of the second comparator CMP2 is configured to input the second reference voltage ref_oc2 corresponding to a second threshold; an output port of the second comparator CMP2 is connected to a first input port of the AND gate AND; a second input port of the AND gate AND is configured to input the first PWM signal PWM1; and an output port of the AND gate AND is connected to an input port of the seventh one shot OS7. When the second voltage signal CS2 is greater than the second reference voltage ref_oc2, the AND gate AND outputs the overcurrent state signal OCS. Optionally, the AND gate AND outputs the overcurrent state signal OCS by using an output port of the seventh one shot OS7. The overcurrent state detection circuit 22 may be applied to the totem-pole bridgeless PFC circuit shown in FIG. 6.

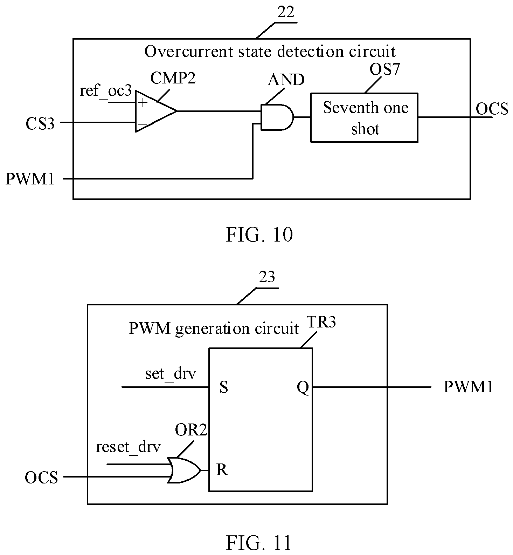

In another possible implementation, as shown in FIG. 10, a difference from FIG. 9 lies in that a non-inverting input + of a second comparator CMP2 is configured to input a third reference voltage ref_oc3 corresponding to a second threshold, and an inverting input - of the second comparator CMP2 is configured to input the third voltage signal CS3 corresponding to the current flowing through the second MOS transistor. When the third voltage signal CS3 is less than the third reference voltage ref_oc3, an AND gate AND outputs the overcurrent state signal OCS. Optionally, the AND gate AND outputs the overcurrent state signal OCS by using an output port of a seventh one shot OS7. The overcurrent state detection circuit 22 may be applied to the totem-pole bridgeless PFC circuit shown in FIG. 7.

In a possible implementation, as shown in FIG. 11, the PWM signal generation circuit 23 includes a second OR gate OR2 and the third trigger TR3. A first input port of the second OR gate OR2 is configured to input a reset signal reset_drv of the first PWM signal PWM1; a second input port of the second OR gate OR2 is configured to input the overcurrent status signal OCS; an output port of the second OR gate OR2 is connected to a reset port R of the third trigger TR3; a data input port S of the third trigger TR3 is configured to input a set signal set_drv of the first PWM signal PWM1; and an output port of the first trigger TR3 is configured to output the first PWM signal PWM1.

Working principles of the PFC circuits shown in FIG. 6 and FIG. 7 are as follows.

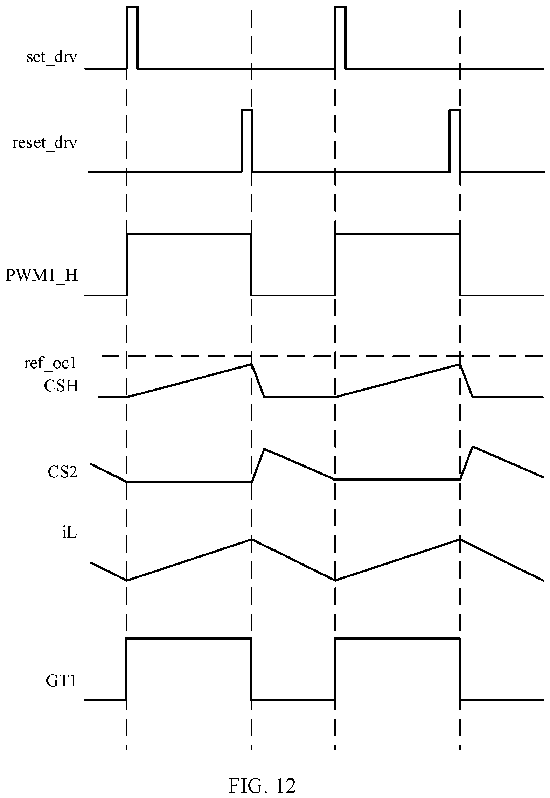

As shown in FIG. 8, FIG. 11, and FIG. 12, when the PFC circuit works normally, the set signal set drv of the first PWM signal PWM1 is at a high level. In this case, the third trigger TR3 is triggered to output the first PWM signal PWM1, and the PWM signal PWM1_H obtained after the level shift circuit 12 performs level shift is at a high level. When the reset signal reset_drv of the first PWM signal PWM1 is at a high level, a third trigger TR3 is triggered to reset, and the PWM signal PWM1_H obtained after the level shift circuit 12 performs level shift on the first PWM signal PWM1 is at a low level.

When the voltage of the neutral line of the alternating current power supply Vac is a positive voltage, a voltage CSH corresponding to the current flowing through the first MOS transistor Q1 is lower than the first reference voltage ref_oc1 corresponding to the first threshold, and a signal OC obtained after an output voltage of the first comparator CMP1 passes through the sixth one shot OS6 is at a low level. For example, the first reference voltage ref_oc1 is 0.3 V.

If the PWM signal PWM1_H obtained after the first PWM signal PWM1 is boosted by the level shift circuit 12 is at a high level, the PWM signal PWM1_H is at a low level after being inverted by an inverter NOT2 in the first drive circuit 13. Because the two input ports of the first OR gate OR1 are at a low level, the PWM signal PWM1_H is output at a low level, which does not trigger the first trigger TR1 to reset. When the PWM signal PWM1_H is at a high level, an output signal of the first trigger TR1 is at a high level, and the signal GT1 obtained after a current is amplified by the first amplifier AMP 1 is also at a high level. In this case, the first MOS transistor Q1 is driven to be turned on, the alternating current power supply Vac charges the inductor L by using the first MOS transistor Q1, and a current iL of the inductor L gradually increases.

If the PWM signal PWM1_H obtained after the first PWM signal PWM1 is boosted by the level shift circuit 12 is at a low level, the PWM signal PWM1_H is at a high level after being inverted by the inverter NOT2 in the first drive circuit 13, and is output at a high level by the first OR gate OR1, which triggers the first trigger TR1 to reset. When the output signal of the first trigger TR1 is at a low level, the signal GT1 output by the first amplifier AMP1 is also at a low level, which drives the first MOS transistor Q1 to be turned off. Because the current of the inductor L does not suddenly change, when the inductor L discharges by using the second MOS transistor Q2, the current iL of the inductor L gradually decreases. Because the drain of the second MOS transistor Q2 has a ground equivalent capacitance and a value is small, the voltage CSH corresponding to the current flowing through the first MOS transistor Q1 rapidly decreases, and the voltage CS corresponding to the current flowing through the second MOS transistor slowly decreases after increasing rapidly.

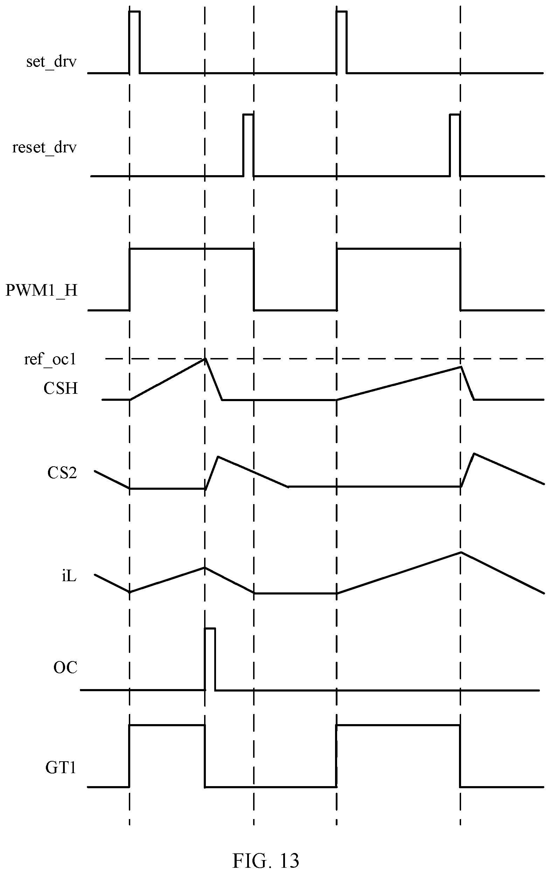

In a charging process of the inductor L, when the voltage CSH corresponding to the current flowing through the first MOS transistor Q1 is higher than the first threshold (that is, an overcurrent is generated), as shown in FIG. 8 and FIG. 13, the voltage CSH corresponding to the current flowing through the first MOS transistor Q1 is higher than the first reference voltage ref_oc1 corresponding to the first threshold, the signal OC obtained after the output voltage of the first comparator CMP1 passes through the sixth one shot OS6 is at a high level, and is output at a high level by the first OR gate OR1, which triggers the first trigger TR1 to reset. When the output signal of the first trigger TR1 is at a low level, the signal GT1 output by the first amplifier AMP 1 is also at a low level, which drives the first MOS transistor Q1 to be turned off. Therefore, the current iL of the sense L gradually decreases, the voltage CSH corresponding to the current flowing through the first MOS transistor Q1 rapidly decreases, and the voltage CS corresponding to the current flowing through the second MOS transistor slowly decreases after rapidly increasing, thereby protecting the first MOS transistor Q1.

Although the first MOS transistor Q1 is turned off, the first PWM signal PWM1 output by the control circuit 11 is still at a high level. Freewheeling can be implemented in the second MOS transistor Q2 due to a body diode. Therefore, the current flowing through the second MOS transistor Q2 still rapidly increases, which corresponds to a rapid increase of the voltage CS in FIG. 6 and a rapid decrease of the voltage CS in FIG. 7.

If the current flowing through the second MOS transistor Q2 exceeds the second threshold, the voltage CS is positive for the totem-pole bridgeless PFC circuit shown in FIG. 6. As shown in FIG. 9, the voltage CS corresponding to the current flowing through the second MOS transistor Q2 is greater than the second reference voltage ref_oc2 corresponding to the second threshold, and the voltage CS is negative for the totem-pole bridgeless PFC circuit shown in FIG. 7. As shown in FIG. 10, the voltage CS corresponding to the current flowing through the second MOS transistor Q2 is less than the third reference voltage ref_oc3 corresponding to the second threshold.

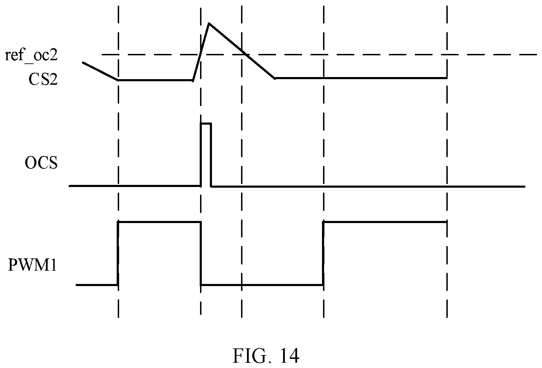

For example, as shown in FIG. 9 and FIG. 14, the second comparator CMP2 outputs a high level, the AND gate AND outputs a high level, and the overcurrent status signal OCS output by the seventh one shot OS7 is at a high level. As shown in FIG. 11 and FIG. 14, the second OR gate OR2 outputs a high level, which triggers the third trigger TR3 to reset, and the first PWM signal PWM1 output by the third trigger TR3 changes to a low level. Therefore, fast reset of the PWM signal is implemented.

According to the totem-pole bridgeless power factor correction circuit and the power electronics device provided in the embodiments of this application, when the first voltage signal corresponding to the current flowing through the first MOS transistor is greater than the first reference voltage, that is, the current flowing through the first MOS transistor is greater than a threshold, the first comparator outputs the overcurrent signal to the first drive circuit, to trigger the first trigger to reset, thereby turning off the first MOS transistor. Therefore, the MOS transistor is quickly turned off when the overcurrent is generated, thereby preventing damage to the MOS transistor.

In addition, similar to the foregoing overcurrent protection for the first MOS transistor Q1, a current detection circuit, an overcurrent state detection circuit, and a PWM signal generation circuit for the second MOS transistor Q2 may also be disposed, to perform overcurrent protection on the second MOS transistor Q2 when a voltage of the live line (live line) of Vac is a positive voltage, which is not discussed here.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A totem-pole bridgeless power factor correction circuit, comprising a first drive circuit, a rectifier bridge, an inductor, and a current detection circuit, wherein the rectifier bridge comprises a first metal oxide semiconductor MOS transistor and a first resistor that are located in a first bridge arm, and a first diode located in a second bridge arm; a first port of the first MOS transistor is connected to a first output port of an alternating current power supply through the first resistor and the inductor, a second port of the first MOS transistor is connected to a cathode of the first diode, and an anode of the first diode is connected to a second output port of the alternating current power supply; an input port of the current detection circuit is connected between the first resistor and the inductor, an output port of the current detection circuit is connected to a second input port of the first drive circuit, an output port of the first drive circuit is connected to a gate of the first MOS transistor, and an input port of the first drive circuit is configured to input a first pulse width modulation PWM signal; one of the first port and the second port of the first MOS transistor is a drain and the other is a source;
when a voltage of the second output port of the alternating current power supply is a positive voltage, the first drive circuit is configured to drive, based on the first PWM signal, the first port and the second port of the first MOS transistor to be turned on, to enable the alternating current power supply to charge the inductor by using the first MOS transistor;
the first resistor is configured to convert a current flowing through the first MOS transistor into a corresponding first voltage signal;
the current detection circuit is configured to: when the first voltage signal exceeds a first reference voltage, output an overcurrent signal to the first drive circuit by using the output port; and
the first drive circuit is further configured to: when receiving the overcurrent signal, drive the first MOS transistor to be turned off.

2. The totem-pole bridgeless power factor correction circuit according to claim 1, wherein
the first drive circuit comprises a first OR gate and a first trigger, the first OR gate is configured to input a phase-inverted signal of the first pulse width modulation PWM signal and the overcurrent signal, an output port of the first OR gate is connected to a reset port of the first trigger, a data input port of the first trigger is configured to input the first PWM signal, and a data output port of the first trigger is connected to the gate of the first MOS transistor.

3. The totem-pole bridgeless power factor correction circuit according to claim 2, wherein the first drive circuit further comprises a first one shot, a second one shot, a NOT gate, and a first amplifier; and
an input port of the first one shot and an input port of the NOT gate are configured to input the first PWM signal, an output port of the first one shot is connected to the data input port of the first trigger, an output port of the NOT gate is connected to an input port of the second one shot, the output port of the NOT gate is configured to output the phase-inverted signal of the first PWM signal, an output port of the second one shot is connected to a first input port of the first OR gate, a second input port of the first OR gate is configured to input the overcurrent signal, the data output port of the first trigger is connected to an input port of the first amplifier, and an output port of the first amplifier is connected to the gate of the first MOS transistor.

4. The totem-pole bridgeless power factor correction circuit according to any one of claims 1 to 3, wherein
the current detection circuit comprises a first comparator, a non-inverting input of the first comparator is configured to input the first voltage signal, and an inverting input of the first comparator is configured to input the first reference voltage; and when the first voltage signal is greater than the first reference voltage, the first comparator outputs the overcurrent signal to the first drive circuit.

5. The totem-pole bridgeless power factor correction circuit according to claim 4, wherein the current detection circuit further comprises a sixth one shot; and
an output port of the first comparator is connected to an input port of the sixth one shot, and the first comparator outputs the overcurrent signal by using an output port of the sixth one shot.

6. The totem-pole bridgeless power factor correction circuit according to any one of claims 1 to 5, wherein the totem-pole bridgeless power factor correction circuit further comprises a PWM signal generation circuit, an overcurrent state detection circuit, and a second resistor; the rectifier bridge further comprises a second MOS transistor located in a third bridge arm, and a second diode located in a fourth bridge arm, a first port of the second MOS transistor is connected between the first resistor and the inductor, a second port of the second MOS transistor is connected to an anode of the second diode, and a cathode of the second diode is connected to the second output port of the alternating current power supply; one of the first port and the second port of the second MOS transistor is a drain and the other is a source; a first input port of the overcurrent state detection circuit is configured to input the first PWM signal, a second input port of the overcurrent state detection circuit is connected between the second port of the second MOS transistor and the anode of the second diode through the second resistor, and an output port of the overcurrent state detection circuit is connected to an input port of the PWM signal generation circuit; the PWM signal generation circuit is configured to generate the first PWM signal;
if the first MOS transistor is turned off due to the overcurrent signal, the inductor discharges by using the second MOS transistor;
the second resistor is configured to convert a current flowing through the second MOS transistor into a corresponding second voltage signal;
the overcurrent state detection circuit is configured to: when the second voltage signal is greater than a second reference voltage, output an overcurrent state signal to the PWM signal generation circuit by using the output port; and
the PWM signal generation circuit is configured to: when receiving the overcurrent state signal, stop outputting the first PWM signal.

7. The totem-pole bridgeless power factor correction circuit according to any one of claims 1 to 5, wherein the totem-pole bridgeless power factor correction circuit further comprises a PWM signal generation circuit, an overcurrent state detection circuit, and a second resistor; the rectifier bridge further comprises a second MOS transistor located in a third bridge arm, and a second diode located in a fourth bridge arm, a first port of the second MOS transistor is connected between the first resistor and the inductor, a second port of the second MOS transistor is connected to an anode of the second diode through the second resistor, and a cathode of the second diode is connected to the second output port of the alternating current power supply; one of the first port and the second port of the second MOS transistor is a drain and the other is a source; a first input port of the overcurrent state detection circuit is configured to input the first PWM signal, a second input port of the overcurrent state detection circuit is connected between the second port of the second MOS transistor and the second resistor, and an output port of the overcurrent state detection circuit is connected to an input port of the PWM signal generation circuit; the PWM signal generation circuit is configured to generate the first PWM signal;
if the first MOS transistor is turned off due to the overcurrent signal, the inductor discharges by using the second MOS transistor;
the second resistor is configured to convert a current flowing through the second MOS transistor into a corresponding third voltage signal;
the overcurrent state detection circuit is configured to: when the third voltage signal is less than a third reference voltage, output an overcurrent state signal to the PWM signal generation circuit by using the output port; and
the PWM signal generation circuit is configured to: when receiving the overcurrent state signal, stop outputting the first PWM signal.

8. The totem-pole bridgeless power factor correction circuit according to claim 6, wherein
the overcurrent state detection circuit comprises a second comparator and an AND gate, a non-inverting input of the second comparator is configured to input the second voltage signal, an inverting input of the second comparator is configured to input the second reference voltage, and an output port of the second comparator is connected to the AND gate, the AND gate is further configured to input the first PWM signal; and when the second voltage signal is greater than the second reference voltage, the AND gate outputs the overcurrent state signal.

9. The totem-pole bridgeless power factor correction circuit according to claim 7, wherein
the overcurrent state detection circuit comprises a second comparator and an AND gate, a non-inverting input of the second comparator is configured to input the third reference voltage, an inverting input of the second comparator is configured to input the third voltage signal, an output port of the second comparator is connected to the AND gate, and the AND gate is further configured to input the first PWM signal; and when the third voltage signal is less than the third reference voltage, the AND gate outputs the overcurrent state signal.

10. The totem-pole bridgeless power factor correction circuit according to claim 8 or 9, wherein the overcurrent state detection circuit further comprises a seventh one shot; and an output port of the AND gate is connected to an input port of the seventh one shot, and the AND gate outputs the overcurrent state signal by using an output port of the seventh one shot.

11. The totem-pole bridgeless power factor correction circuit according to any one of claims 6 to 9, wherein the PWM signal generation circuit comprises a second OR gate and a third trigger, the second OR gate is configured to input a reset signal of the first PWM signal and the overcurrent state signal, an output port of the second OR gate is connected to a reset port of the third trigger, a data input port of the third trigger is configured to input a set signal of the first PWM signal, and an output port of the third trigger is configured to output the first PWM signal.

12. A power electronics device, comprising the totem-pole bridgeless power factor correction circuit and a working circuit according to any one of claims 1 to 11, wherein the totem-pole bridgeless power factor correction circuit is configured to output a direct current to the working circuit.
